# EUROPEAN PATENT APPLICATION

(11) **EP 3 629 088 A1**
(43) Date of publication of application: **01.04.2020**
(21) Application number: 18197556.6
(22) Date of filing: 28.09.2018
(51) Int. Cl.: G03F 7/20, G06N 3/02

(54) **PROVIDING A TRAINED NEURAL NETWORK AND DETERMINING A CHARACTERISTIC OF A PHYSICAL SYSTEM**

(71) Applicant: ASML Netherlands B.V., 5500 AH Veldhoven (NL)
(72) Inventor: REHMAN, Samee Ur, 5500 AH Veldhoven (NL)
(74) Representative: Willekens, Jeroen Pieter Frank

(57) **Abstract**

A method of determining a characteristic, such as optical response, of a physical system having a material structure, such as a thin-film multilayer stack or other optical system, has the steps: providing (1430) a neural network (1440) with its network architecture configured based on a model (1420) of scattering of radiation by the material structure along the radiation's path; training (1450) and using (1460) the neural network to determine the characteristic of the physical system. The network architecture may be configured based on the model by configuring parameters including number of units per hidden layer, number of hidden layers, layer interconnection and dropout.

## Description

### FIELD

The present invention relates to methods of providing a trained neural network, methods of determining a characteristic of a physical system, data processing apparatus, inspection apparatus, metrology apparatus, lithographic cells and computer program products.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Artificial neural network and deep learning models have recently received a lot of attention due to their ability to outperform specific models in fields as diverse as objection recognition, machine translation, speech recognition, audio signal processing etc. Their ability to learn useful information for a very diverse set of problems has generated interest in their use in the semiconductor industry. Given the (recent) resurgence of artificial neural networks and deep learning, there has been interest in applying a data-driven approach for performing mapping from input to output for different semiconductor manufacturing applications, for e.g. thin-film multilayer stack parameters of a critical dimension (CD) profile manufactured in a semiconductor manufacturing process (as an input) to the pupil of the objective of a scatterometer (as an output).

Conventionally, whenever such a mapping is performed, a neural network architecture (e.g. the number of layers in the network, the number of hidden units in each layer) must be tuned via a time-consuming process. Different combinations of the hyperparameters (e.g. number of layers, number of hidden units per layer, etc.), for example 5 layers and 4 hidden units per layer, are checked to evaluate which one gives the best overall performance (e.g. lowest training data error, lowest mean squared error on test data). This process of finding the optimal architecture for a particular application involves a lot of trial and error with loss of both computational as well as human expert time.

A concern for machine learning models is generalization, i.e. correct prediction for data the model has not seen during training. Coming up with the optimal architecture such that the network generalizes well to new data is also a basic open problem in machine learning related research.

### SUMMARY

It is desirable to provide effective and efficient solutions for training neural networks and using them to determine characteristics of a physical system, such as a thin-film multilayer stack, that solves one or more of the above-discussed problems or limitations.

Embodiments of the invention are disclosed in the claims and in the detailed description.

In a first aspect of the invention there is provided a method of providing a trained neural network, the method comprising the steps:
- providing a neural network with its network architecture configured based on a model of scattering of radiation by a material structure of a physical system along the radiation's path; and
- training the neural network.

In a second aspect of the invention there is provided a method of determining a characteristic of a physical system having a material structure, the method comprising the steps:
- receiving a trained neural network with its network architecture configured based on a model of scattering of radiation by the material structure along the radiation's path; and
- using the trained neural network to determine the characteristic of the physical system.

In a third aspect of the invention there is provided a data processing apparatus, comprising a neural network with its network architecture configured based on a model of scattering of radiation by a material structure of a physical system along the radiation's path.

In a fourth aspect of the invention there is provided an inspection apparatus for reconstructing an approximate structure of physical system having a material structure, the inspection apparatus comprising:
- an illumination system configured to illuminate the physical system with radiation;
- a detection system configured to detect a detected characteristic of physical system arising from the illumination; and
- a processor configured to:
   - determine at least one model characteristic of the physical system using a method according to the second aspect; and
   - determine an approximate structure of the physical system from a difference between said detected characteristic and said at least one model characteristic of the physical system.

In a fifth aspect of the invention there is provided a metrology apparatus comprising the inspection apparatus of the fourth aspect.

In a sixth aspect of the invention there is provided a lithographic cell comprising the inspection apparatus of the fourth aspect.

In a seventh aspect of the invention there is provided a computer program product comprising machine readable instructions for causing a general-purpose data processing apparatus to perform the steps of a method of the first or second aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4a illustrates a scatterometer inspection apparatus according to an embodiment of the invention;
- Figure 4b illustrates another scatterometer inspection apparatus according to an embodiment of the invention;
- Figure 5 depicts a first example process using an embodiment of the invention for reconstruction of an approximate structure from scatterometer measurements;
- Figure 6 depicts a second example process using an embodiment of the invention for reconstruction of an approximate structure from scatterometer measurements;
- Figure 7 depicts a schematic representation of a neural network being used to generate a mapping from x to y;
- Figure 8 depicts a schematic representation of a thin-film multilayer stack with scattering of radiation by material structure along the radiation's path;
- Figure 9 depicts a schematic representation of a neural network with its network architecture configured in accordance with an embodiment of the present invention;
- Figure 10 depicts a schematic representation of a patterned thin-film multilayer stack with scattering of radiation by material structure along the radiation's path through different pattern areas;
- Figure 11 depicts a schematic representation of a neural network with its network architecture configured in accordance with an embodiment of the present invention based on the model of scattering of radiation by material structure of the physical system depicted in Figure 10;
- Figure 12 depicts a schematic representation of a neural network with its network architecture configured in accordance with an embodiment of the present invention with a second neural network in parallel;
- Figure 13 depicts a schematic representation of a neural network with its network architecture configured in accordance with an embodiment of the present invention by configuring dropout; and
- Figure 14 depicts a flow chart of methods in accordance with embodiments of the present invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

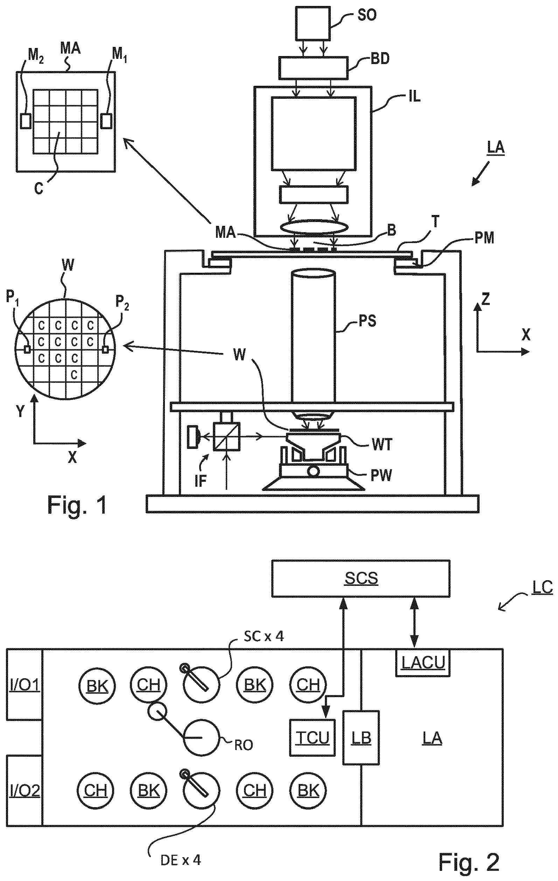

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

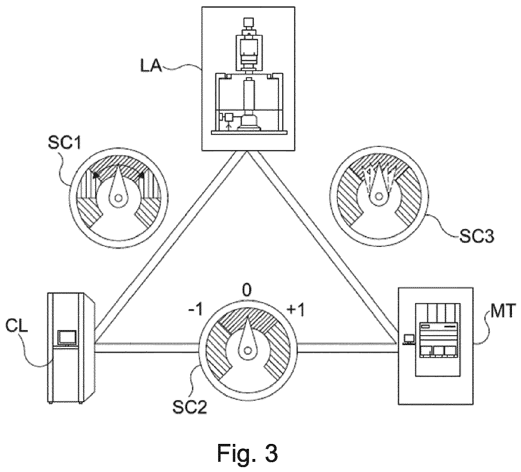

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

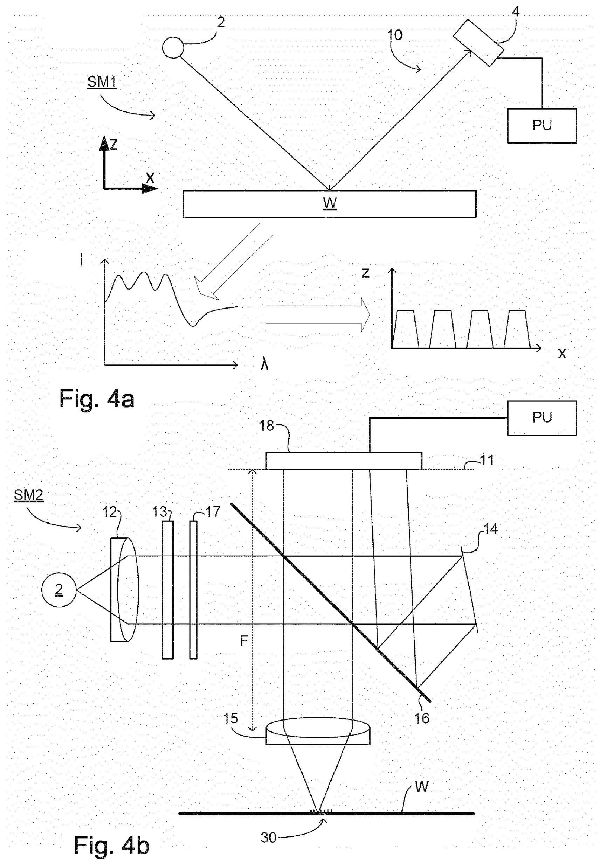

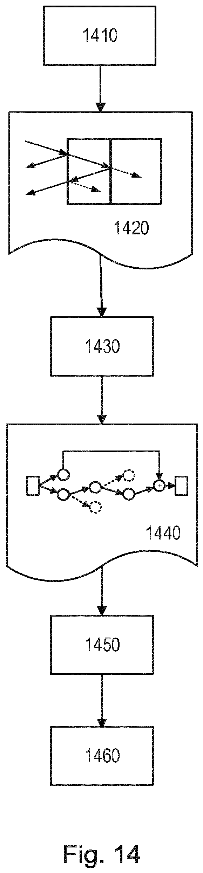

Figure 4a depicts a scatterometer as an example of a metrology apparatus, which may be used in an embodiment of the present invention. It comprises a broadband (white light) radiation projector 2 which projects radiation 5 onto a physical system, in this example a substrate W. The reflected or scattered radiation 10 is passed to a spectrometer detector 4, which measures a spectrum 6 (i.e. a measurement of intensity I as a function of wavelength λ) of the specular reflected radiation 10. From this data, the structure or profile 8 giving rise to the detected spectrum may be reconstructed by processing unit PU, using methods of providing a trained neural network and determining a characteristic of a physical system, such as described with reference to Figure 14, and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Another scatterometer that may be used in an embodiment of the present invention is shown in Figure 4b. In this device, the radiation emitted by radiation source 2 is focused using lens system 12 through interference filter 13 and polarizer 17, reflected by partially reflected surface 16 and is focused onto substrate W via a microscope objective lens 15, which has a high numerical aperture (NA), preferably at least 0.9 and more preferably at least 0.95. Immersion scatterometers may even have lenses with numerical apertures over 1. The reflected radiation then transmits through partially reflective surface 16 into a detector 18 in order to have the scatter spectrum detected. The detector may be located in the back-projected pupil plane 11, which is at the focal length of the lens system 15, however the pupil plane may instead be re-imaged with auxiliary optics (not shown) onto the detector. The pupil plane is the plane in which the radial position of radiation defines the angle of incidence and the angular position defines azimuth angle of the radiation. The detector is preferably a two-dimensional detector so that a two-dimensional angular scatter spectrum of a physical system, in this example substrate target 30, can be measured. The detector 18 may be, for example, an array of CCD or CMOS sensors, and may use an integration time of, for example, 40 milliseconds per frame.

A reference beam is often used for example to measure the intensity of the incident radiation. To do this, when the radiation beam is incident on the beam splitter 16 part of it is transmitted through the beam splitter as a reference beam towards a reference mirror 14. The reference beam is then projected onto a different part of the same detector 18.

A set of interference filters 13 is available to select a wavelength of interest in the range of, say, 405 - 790 nm or even lower, such as 200 - 300 nm. The interference filter may be tunable rather than comprising a set of different filters. A grating could be used instead of interference filters.

The detector 18 may measure the intensity of scattered light at a single wavelength (or narrow wavelength range), the intensity separately at multiple wavelengths or integrated over a wavelength range. Furthermore, the detector may separately measure the intensity of transverse magnetic- and transverse electric-polarized light and/or the phase difference between the transverse magnetic- and transverse electric-polarized light.

Using a broadband light source (i.e. one with a wide range of light frequencies or wavelengths - and therefore of colors) is possible, which gives a large etendue, allowing the mixing of multiple wavelengths. The plurality of wavelengths in the broadband preferably each has a bandwidth of Δλ and a spacing of at least 2 Δλ (i.e. twice the bandwidth). Several "sources" of radiation can be different portions of an extended radiation source which have been split using fiber bundles. In this way, angle resolved scatter spectra can be measured at multiple wavelengths in parallel. A 3-D spectrum (wavelength and two different angles) can be measured, which contains more information than a 2-D spectrum. This allows more information to be measured which increases metrology process robustness. This is described in more detail in EP1,628,164A.

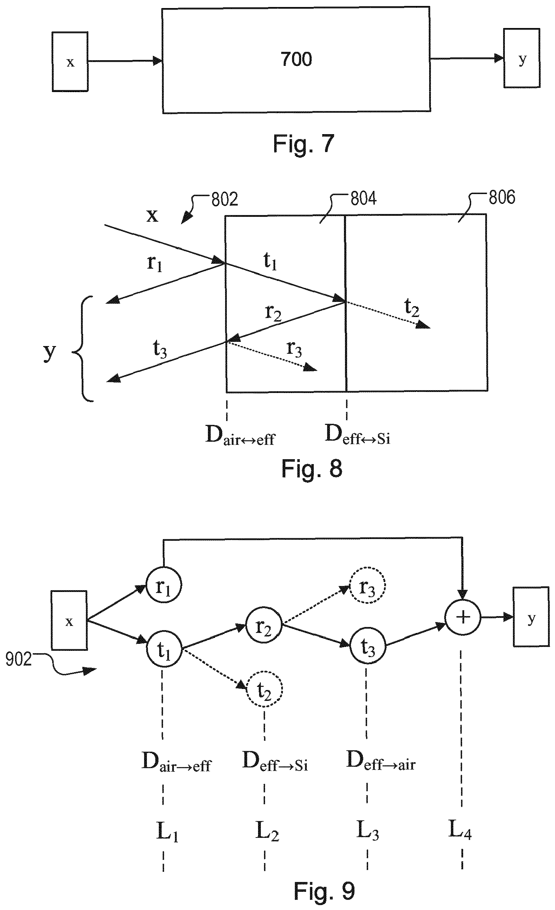

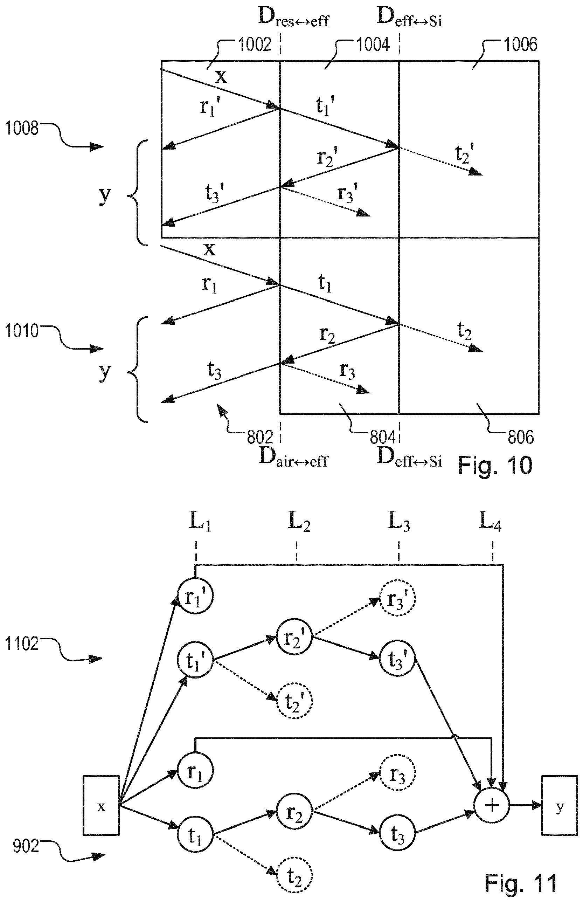

The target 30 on substrate W may be a grating, which is printed such that after development, the bars are formed of solid resist lines. The bars may alternatively be etched into the substrate. This pattern is sensitive to chromatic aberrations in the lithographic projection apparatus, particularly the projection system PL, and illumination symmetry and the presence of such aberrations will manifest themselves in a variation in the printed grating. Accordingly, the scatterometry data of the printed gratings is used to reconstruct the gratings. The parameters of the grating, such as line widths and shapes and material structure of the thin-film multilayer stack such as described with reference to Figures 8 and 10, may be input to the reconstruction process, performed by processing unit PU using methods of providing a trained neural network and determining a characteristic of a physical system, such as described with reference to Figure 14, from knowledge of the printing step and/or other scatterometry processes.

As described above, the target is on the surface of the substrate. This target will often take the shape of a series of lines in a grating or substantially rectangular structures in a 2-D array. The purpose of rigorous optical diffraction theories in metrology is effectively the calculation of a diffraction spectrum that is reflected from the target. In other words, target shape information is obtained for CD (critical dimension) uniformity and overlay metrology. Overlay metrology is a measuring system in which the overlay of two targets is measured in order to determine whether two layers on a substrate or aligned or not. CD uniformity is simply a measurement of the uniformity of the grating on the spectrum to determine how the exposure system of the lithographic apparatus is functioning. Specifically, CD, or critical dimension, is the width of the object that is "written" on the substrate and is the limit at which a lithographic apparatus is physically able to write on a substrate.

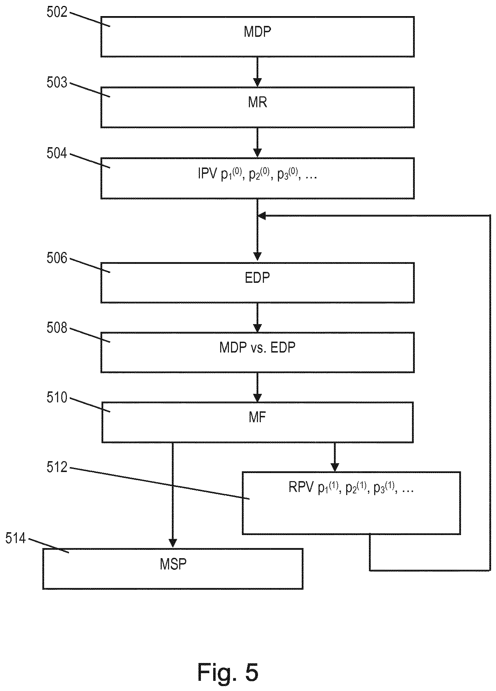

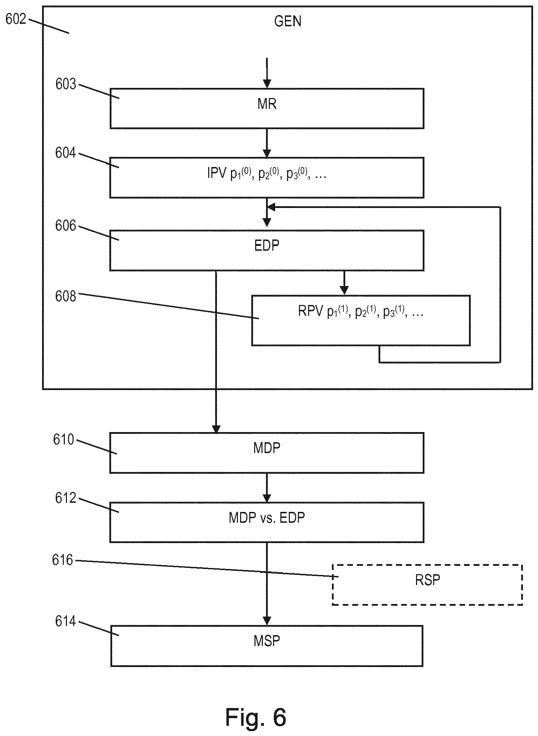

Using one of the scatterometers described above in combination with modeling of a target structure such as the target 30 and its diffraction properties, measurement of the shape and other parameters of the structure can be performed in a number of ways. In a first type of process, represented by Figure 5, a diffraction pattern based on a first estimate of the target shape (a first candidate structure) is calculated and compared with the observed diffraction pattern. Parameters of the model are then varied systematically and the diffraction re-calculated in a series of iterations, to generate new candidate structures and so arrive at a best fit. In a second type of process, represented by Figure 6, diffraction spectra for many different candidate structures are calculated in advance to create a 'library' of diffraction spectra. Then the diffraction pattern observed from the measurement target is compared with the library of calculated spectra to find a best fit. Both methods can be used together: a coarse fit can be obtained from a library, followed by an iterative process to find a best fit.

Referring to Figure 5 in more detail, the way the measurement of the target shape and/or material properties is carried out will be described in summary. The target will be assumed for this description to be a 1-dimensional (1-D) structure. In practice it may be 2-dimensional, and the processing will be adapted accordingly.

502: The diffraction pattern of the actual target on the substrate is measured using a scatterometer such as those described above. This measured diffraction pattern (MDP) is forwarded to a calculation system such as a computer. The calculation system may be the processing unit PU referred to above, or it may be a separate apparatus.

503: A 'model recipe' (MR) is established which defines a parameterized model of the target structure in terms of a number of parameters pᵢ (p₁, p₂, p₃ and so on). These parameters may represent for example, in a 1D periodic structure, the angle of a side wall, the height or depth of a feature, the width of the feature. Properties of the target material and underlying layers are also represented by parameters such as refractive index (at a particular wavelength present in the scatterometry radiation beam). Specific examples will be given below. Importantly, while a target structure may be defined by dozens of parameters describing its shape and material properties, the model recipe will define many of these to have fixed values, while others are to be variable or 'floating' parameters for the purpose of the following process steps. Further below we describe the process by which the choice between fixed and floating parameters is made. Moreover, we shall introduce ways in which parameters can be permitted to vary without being fully independent floating parameters. For the purposes of describing Figure 5, only the variable parameters are considered as parameters pᵢ

504: A model target shape is estimated by setting initial parameter values (IPV) pᵢ⁽⁰⁾ for the floating parameters (i.e. p₁⁽⁰⁾, p₂⁽⁰⁾, p₃⁽⁰⁾ and so on). Each floating parameter will be generated within certain predetermined ranges, as defined in the recipe.

506: The shape parameters representing the estimated shape, together with the optical properties of the different elements of the model, are used to determine the scattering properties, for example using methods of providing a trained neural network and determining a characteristic of a physical system, such as described with reference to Figure 14. This gives an estimated or model diffraction pattern (EDP) of the estimated target shape. Conventionally, this may have been calculated using a rigorous optical diffraction method such as RCWA or another solver of Maxwell equations.

508, 510: The measured diffraction pattern MDP and the model or estimated diffraction EDP pattern are then compared and their similarities and differences are used to calculate a "merit function" (MF) for the model target shape.

512: Assuming that the merit function indicates that the model needs to be improved before it represents accurately the actual target shape, new revised parameter values (RPV) p₁⁽¹⁾, p₂⁽¹⁾, p₃⁽¹⁾, etc. are estimated and fed back iteratively into step 506. Steps 506-512 are repeated.

In order to assist the search, the calculations in step 506 may further generate partial derivatives of the merit function, indicating the sensitivity with which increasing or decreasing a parameter will increase or decrease the merit function, in this particular region in the parameter space. The calculation of merit functions and the use of derivatives is generally known in the art, and will not be described here in detail.

514: When the merit function indicates that this iterative process has converged on a solution with a desired accuracy, the currently estimated parameters are reported as the measurement of the actual target structure or measured shape parameters (MSP).

The estimated or model diffraction pattern calculated at 506 can be expressed in various forms. Comparisons are simplified if the calculated pattern is expressed in the same form as the measured pattern generated in step 510. For example, a modeled spectrum can be compared easily with a spectrum measured by the apparatus of Figure 4a; a modeled pupil pattern can be compared easily with a pupil pattern measured by the apparatus of Figure 4b.

Throughout this description from Figure 5 onward, the term 'diffraction pattern' will be used, on the assumption that the scatterometer of Figure 4a is used. The skilled person can readily adapt the teaching to different types of scatterometer, or even other types of measurement instrument.

Figure 6 illustrates an alternative example process in which plurality of model diffraction patterns for different estimated target shapes (candidate structures) are calculated in advance and stored in a library for comparison with a real measurement. The underlying principles and terminology are the same as for the process of Figure 5. The steps of the Figure 6 process are:
602: The process of generating (GEN) the library begins. A separate library may be generated for each type of target structure. The library may be generated by a user of the measurement apparatus according to need, or may be pre-generated by a supplier of the apparatus.
603: A 'model recipe' (MR) is established which defines a parameterized model of the target structure in terms of a number of parameters pᵢ (p₁, p₂, p₃ and so on). Considerations are similar to those in step 503 of the iterative process.
604: A first set of initial parameter values (IPV) p₁⁽⁰⁾, p₂⁽⁰⁾, p₃⁽⁰⁾, etc. is generated, for example by generating random values of all the parameters, each within its expected range of values.
606: A estimated or model diffraction pattern (EDP) is calculated and stored in a library, representing the diffraction pattern expected from a target structure represented by the parameters.
608: A new set of revised shape parameter values (RPV) p₁⁽¹⁾, p₂⁽¹⁾, p₃⁽¹⁾, etc. is generated. Steps 606-608 are repeated tens, hundreds or even thousands of times, until the library which comprises all the stored modeled diffraction patterns is judged sufficiently complete. Each stored pattern represents a sample point in the multi-dimensional parameter space. The samples in the library should populate the sample space with a sufficient density that any real diffraction pattern will be sufficiently closely represented.
610: After the library is generated (though it could be before), the real target 30 is placed in the scatterometer and its measured diffraction pattern (MDP) is measured.
612: The measured pattern (MDP) is compared with the estimated or modeled diffraction patterns (EDP) stored in the library to find the best matching pattern. The comparison may be made with every sample in the library, or a more systematic searching strategy may be employed, to reduce computational burden.
614: If a match is found then the estimated target shape used to generate the matching library pattern can be determined to be the approximate object structure. The shape parameters corresponding to the matching sample are output as the measured shape parameters (MSP). The matching process may be performed directly on the model diffraction signals, or it may be performed on substitute models which are optimized for fast evaluation.
616: Optionally, the nearest matching sample is used as a starting point, and a refinement process (refine shape parameters, RSP) is used to obtain the final parameters for reporting. This refinement process may comprise an iterative process very similar to that shown in Figure 5, for example.

Whether refining step 616 is needed or not is a matter of choice for the implementer. If the library is very densely sampled, then iterative refinement may not be needed because a good match will always be found. On the other hand, such a library might too large for practical use. A practical solution is thus to use a library search for a coarse set of parameters, followed by one or more iterations using the merit function to determine a more accurate set of parameters to report the parameters of the target substrate with a desired accuracy. Where additional iterations are performed, it would be an option to add the calculated diffraction patterns and associated refined parameter sets as new entries in the library. In this way, a library can be used initially which is based on a relatively small amount of computational effort, but which builds into a larger library using the computational effort of the refining step 616. Whichever scheme is used, a further refinement of the value of one or more of the reported variable parameters can also be obtained based upon the goodness of the matches of multiple candidate structures. For example, the parameter values finally reported may be produced by interpolating between parameter values of two or more candidate structures, assuming both or all of those candidate structures have a high matching score.

The computation time of this iterative process is largely determined by the forward diffraction model at steps 506 and 606. Conventionally, the determination of the estimated model diffraction pattern has been performed using a rigorous optical diffraction theory from the estimated target shape. In embodiments, it is performed using methods of providing a trained neural network and determining a characteristic of a physical system, such as described with reference to Figure 14.

Figure 7 depicts a schematic representation of a neural network being used to generate a mapping from x to y. Here, the neural network 700 is a black-box model learnt purely based on training data. The neural network architecture is determined using conventional approaches.

Figure 8 depicts a schematic representation of a thin-film multilayer stack with scattering of radiation by material structure along the radiation's path. In this example, the physical system is the thin-film multilayer stack that comprises air 802, an effective medium 804 and silicon 806. The thin-film multilayer stack can be manufactured in a semiconductor manufacturing process. Air or vacuum can be considered as part of the thin-film multilayer stack. The layers may be solid, liquid or gas. The thin-film multilayer stack can also be manufactured by other processes than thin-layer manufacturing processes. The thin-film multilayer stack is not necessarily present on a semiconductor wafer. For example, it may be thin-film multilayer stack present on a mirror. Radiation x passes through air 802 and is incident upon an interface D_{air↔eff}, which is a discontinuity in the material structure, being an interface between air 802 and the effective medium 804. Some radiation, r₁ is reflected back into the air 802 and some radiation t₁ is transmitted into the effective medium 804. The reflected radiation r₁ contributes directly to the overall optical response y. Transmitted radiation t₁ follows a path through the effective medium 804 to another discontinuity D_{eff↔Si} between the effective medium 804 and silicon 806. At this discontinuity some radiation t₂ is transmitted through into the silicon 806 and it does not contribute to the overall optical response y. However, radiation r₂ is reflected from the discontinuity back through the effective medium 804 to the interface D_{air↔eff} between the effective medium 804 and the air 802. At that discontinuity D_{air↔eff} some radiation r₃ is reflected back into the effective medium 804 and it does not contribute significantly through further reflections to the overall optical response y. Furthermore, at that discontinuity D_{air↔eff}, radiation t₃ is transmitted to the air 802 and added to the initially reflected radiation r₁ to form the optical response y. In this example, the physical system comprises an optical system and a characteristic of the physical system is the optical response of the optical system.

Suppose we are interested in finding out the optical response y of the stack given that light x is incident on the stack. Also suppose that we would like to train a neural network model to perform the input (incident light x) to output (optical response y) mapping. Given training data, known values for x and y, we could train a conventional neural network as a black-box model as shown in Figure 7. In that case, the network architecture of the neural network (e.g. number of layers, number of hidden units per layer, dropout regularization, etc.) is determined through trial and error based on the available data, which has the problem of inefficiency as discussed above.

Figure 9 depicts a schematic representation of a neural network with its network architecture configured in accordance with an embodiment of the present invention. The neural network architecture is motivated by the physics of the scattering of radiation in the physical structure being modeled (Figure 8). In Figures 9 and 11, t represents transmission units and r represents reflection units. The units drawn as solid-line circles represent the units that contribute to the final output. The units drawn as dotted-line circles represent units that do not contribute to the output (which may be left out of the neural network). The neural network has its weights and biases trained given this architecture. Layer 1, Layer 2 and Layer 3 (L₁, L₂ and L₃) in the network model the transmission and reflection at the interfaces of the stack. Layer 4 (L₄) combines the response from Layer 1 and Layer 3 to come up with the final output, y.

Layer 1 corresponds to scattering of radiation x by the discontinuity D_{air↔eff} (note the bidirectional arrow in the subscript) in the direction from air 802 to the effective medium 804, D_{air→eff} (note the single-direction arrow in the subscript). The units r₁ and t₁ in Figure 9 correspond to scattered radiation r₁ and t₁ in the model of scattering depicted in Figure 8. Similarly Layer 2 corresponds to scattering of radiation t₁ by the discontinuity D_{eff↔Si} in the direction from the effective medium 804 to silicon 806, D_{eff→Si}. The units r₂ and t₂ in Figure 9 correspond to scattered radiation r₂ and t₂ in the model of scattering depicted in Figure 8. Furthermore, Layer 3 corresponds to scattering of radiation r₂ by the discontinuity D_{air↔eff} in the direction from the effective medium 804 to air 802, D_{eff→air} (note that the suffix of D_{eff→air} indicates a reversal of direction compared to the discontinuity D_{air→eff} of Layer 1). The units r₃ and t₃ in Figure 9 correspond to scattered radiation r₃ and t₃ in the model of scattering depicted in Figure 8. Thus, a neural network has been provided with its network architecture 902 configured based on a model (Figure 8) of scattering of radiation by a material structure 802, 804, 806 of a physical system along the radiation's path x, t₁, r₂, t₃.

In Figure 9, the transfer of information from Layer 1 to Layer 4, shown by the top arrow representing a connection from unit r₁ to a summation unit "+", can also be seen as modeling a residual neural network, which on a basic level involves skipping one or more layers in-between when connecting units in the neural network. Thus, the step of providing a neural network comprises providing one (or more depending on the material structure) skip connections between non-adjacent neural network layers based on reflection of radiation in the model of scattering of the radiation.

In the examples depicted in Figures 8 to 13, the step of providing the neural network comprises providing different units t and r in a hidden layer corresponding to different respective types of scattering of the radiation with the material structure. The different respective types of scattering of the radiation to which differing units correspond may include reflection, transmission, absorption, refraction, diffraction, interference, polarization, dispersion, elastic scattering, and inelastic scattering. Furthermore, different hidden layers of the neural network correspond to different scattering of the radiation along the radiation's path with different respective portions of the physical system. The portions may comprise material discontinuities such as interfaces between differing material layers. Material discontinuities may also be graded profiles of material properties that affect scattering of radiation or volumes of materials having different inelastic scattering cross-sections.

Figure 10 depicts a schematic representation of a patterned thin-film multilayer stack with scattering of radiation by material structure along the radiation's path through different pattern areas 1008 and 1010.

In this example, the physical system includes in pattern area 1010 a stack that comprises air 802, an effective medium 804 and silicon 806. Radiation x passes through the stack in pattern area 1010 in the same way as described with reference to Figure 8, in which the same reference signs correspond to the same features as Figure 10.

In pattern area 1008, radiation x passes through resist 1002 and is incident upon an interface D_{res↔eff}, which is a discontinuity in the material structure, between resist 1002 and the effective medium 1004. Some radiation, r₁' is reflected back into the resist 1002 and some radiation t₁' is transmitted into the effective medium 1004. The reflected radiation r₁' contributes directly to the overall optical response y. Transmitted radiation t₁' follows a path through the effective medium 1004 to another discontinuity D_{eff↔Si} between the effective medium 1004 and silicon 1006. At this discontinuity some radiation t₂' is transmitted through into the silicon 1006 and it does not contribute to the overall optical response y. However, radiation r₂' is reflected from the discontinuity back through the effective medium 1004 to the interface D_{res↔eff} between the effective medium 1004 and the resist 1002. At that discontinuity D_{res↔eff} some radiation r₃' is reflected back into the effective medium 1004 and it does not contribute significantly through further reflections to the overall optical response y. Furthermore, at that discontinuity D_{res↔eff}, radiation t₃' is transmitted and added, along with radiation t₃ from pattern area 1010, to the initially reflected radiation r₁' and r₁ to form the optical response y. In this example, the physical system comprises an optical system and a characteristic of the physical system is the optical response of the optical system. The physical system here comprises a lithographically patterned (with pattern areas 1008 and 1010) multilayer (with layers of air 802, resist 1002, effective medium 804,1004 and silicon 806, 1006) as the optical system.

Figure 11 depicts a schematic representation of a neural network with its network architecture configured in accordance with an embodiment of the present invention based on the model of scattering of radiation by material structure of the physical system depicted in Figure 10. The neural network architecture is motivated by the physics of the scattering of radiation in the physical structure being modeled (Figure 10).

Layer 1 (L₁) corresponds to scattering of radiation x by the discontinuity D_{air↔eff} in the direction from air 802 to the effective medium 804, D_{air→eff} and also to scattering of radiation x by the discontinuity D_{res↔eff} in the direction from resist 1002 to the effective medium 1004. The units rₙ and tₙ in Figure 11 correspond to scattered radiation rₙ and tₙ in the model of scattering depicted in Figure 10, where n=1,2,3. The units rₙ' and tₙ' in Figure 11 correspond to scattered radiation rₙ' and tₙ' in the model of scattering depicted in Figure 10. In Layer 4 (L4), the outputs of sub-networks 902 (corresponding to pattern area 1010) and 1102 (corresponding to pattern area 1008) are summed.

Thus, a neural network has been provided with its network architecture 902, 1102 configured based on a model (Figure 10) of scattering of radiation by a material structure 802, 804, 806, 1002, 1004, 1006 of a physical system along the radiation's path x, t₁, r₂, t₃ in pattern area 1010 and x, t₁', r₂', t₃' in pattern area 1008.

In Figure 11, the transfer of information from Layer 1 (L₁) to Layer 4 (L₄), shown by the top arrow representing a connection from unit r₁' to a summation unit "+", can also be seen as modeling a residual neural network, which on a basic level involves skipping one or more layers in-between when connecting units in the neural network. Thus, in this example, the step of providing a neural network comprises providing two skip connections (from r₁ and r₁') between non-adjacent neural network layers based on reflection of radiation in the model of scattering of the radiation. These skip connections arise from different pattern areas, but skip connections may also arise corresponding to radiation paths through the same pattern area.

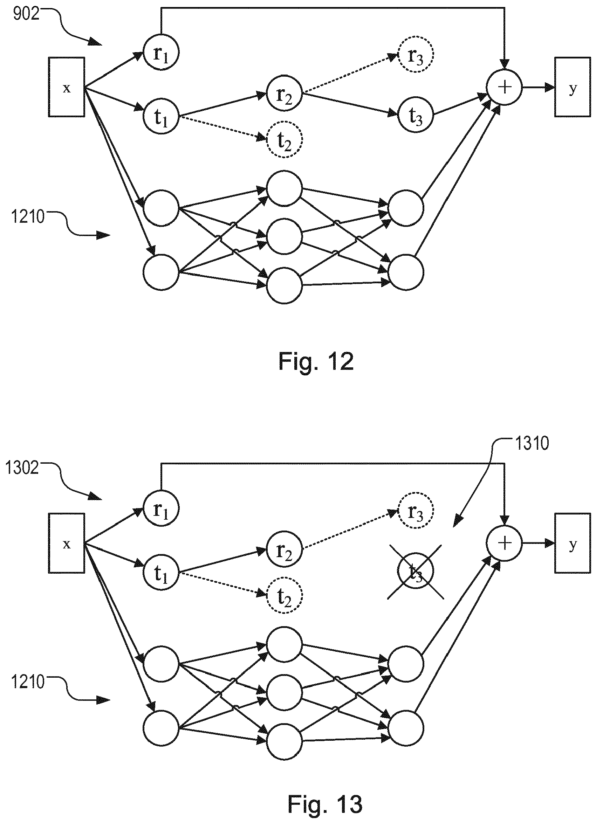

It may be the case that a neural network with its network architecture configured based on the model of scattering of radiation may not be enough to model the complexity of the actual measured data due to, for example, calibration errors. In this case, the radiation-scattering-model based network architecture could be augmented by other units that are added to learn these additional features not represented by the radiation-scattering-model based network architecture. An example of such a network is given in Figure 12, which depicts a schematic representation of a neural network with its network architecture configured in accordance with an embodiment of the present invention with a second neural network in parallel.

Figure 12 illustrates a neural network architecture that augments a network 902 having its network based on the model of scattering of radiation (depicted in Figure 8) with new units 1210 added that try to learn parts of the input-output relationship that cannot be modeled by the radiation-scattering-model based network architecture alone. The new units may have their number of hidden layers and number of units per hidden layer configured using conventional data-driven methods. The neural network 902 having its architecture configured based on the model of scattering of radiation is thus further provided with a second neural network 1210 in parallel and the neural networks share the same input and outputs x and y.

The relative contribution of the data-driven network architecture 1210 and the parallel radiation-scattering-model based network architecture 902 may be scaled up or down by using the concept of dropout regularization. An example of dropout regularization is shown in Figure 13, which depicts a schematic representation of a neural network with its network architecture configured in accordance with an embodiment of the present invention by configuring dropout. Figure 13 thus illustrates an example of dropout regularization. The unit 1310 has been dropped out of the network, i.e. it no longer contributes to the neural network output. If needed, we could drop out the complete radiation-scattering-model based network architecture portion 1302 or the complete data-driven network architecture portion 1210. Dropout regularization also helps with the generalization problem mentioned above (correct prediction for data the model has not seen during training).

It has been shown that the network architecture may be configured based on the model of scattering of radiation by configuring parameters including number of units per hidden layer, number of hidden layers, layer interconnection and dropout.

Figure 14 depicts a flow chart of methods in accordance with embodiments of the present invention.

At step 1410, a model 1420 of scattering of radiation by a material structure of a physical system along the radiation's path is constructed. Such models are described with reference to Figures 8 and 10.

At step 1430, a neural network 1440 is provided with its network architecture configured based on the model 1420. Such neural networks are described with reference to Figures 9 and 11 to 13.

At step 1450 the neural network 1440 is trained. Thus steps 1410 to 1450 describe a method of providing a trained neural network.

A method of determining a characteristic of a physical system having a material structure, has the steps:

At step 1460, the trained neural network 1440 with its network architecture configured based on a model 1420 of scattering of radiation by the material structure along the radiation's path is received. The trained neural network is then used to determine the characteristic of the physical system. In the examples described with reference to Figures 8 to 11, the physical system comprises an optical system and the characteristic comprises an optical response of the optical system. Other suitable optical systems are multilayer mirrors for EUV applications and multi-lens refractive or catadioptric optical systems, such as found in lithographic scanners. The physical system may comprise a thin-film multilayer stack, or layers that are not thin. Rather than layers, the physical system may have physical elements, for example optical elements in a medium such as air, which support the radiation path. However, in other embodiments, the physical system may comprise an acoustic system and the characteristic then comprises an acoustic response of the acoustic system. Examples of radiation in the scattering model may include propagating electromagnetic and mechanical waves, such as ultrasound or seismic radiation, and penetrating radiation (which may include mass transport), such as ionizing radiation. Thus, embodiments may be used for simulation and tomography for a variety of physical systems where a model of scattering of radiation by a material structure of a physical system can be constructed.

A data processing apparatus, such as processing unit PU of figures 4a and 4b, may comprise a neural network implemented in software and/or hardware with its network architecture configured based on a model of scattering of radiation by a material structure of a physical system along the radiation's path, as described with reference to figures 8 to 13.

With reference to Figure 4a, an inspection apparatus SM1 for reconstructing an approximate structure of physical system W having a material structure, may comprise:
- an illumination system 2 configured to illuminate the physical system with radiation;
- a detection system configured to detect a detected characteristic of physical system arising from the illumination; and
- a processor PU configured to:
   - determine at least one model characteristic of the physical system using a method described with reference to Figure 14; and
   - determine an approximate structure of the physical system from a difference between said detected characteristic and said at least one model characteristic of the physical system.

Thus, a metrology apparatus such as depicted in Figure 4a or 4b may comprise this inspection apparatus. Furthermore, a lithographic cell LC such as depicted in Figure 2 may comprise this inspection apparatus.

A computer program product comprising machine readable instructions for causing a general-purpose data processing apparatus may be used to perform the steps of a method described with reference to Figure 14.

Embodiments provide the optimal architecture for determining characteristics of a physical system, while avoiding trial and error. This saves both computational and human expert time. Embodiments also improve generalization, i.e. thus the provided neural network generalizes well to new data, which the neural network model has not seen during training.

Further embodiments are disclosed in the subsequent numbered clauses:
1. A method of providing a trained neural network, the method comprising the steps:
   - providing a neural network with its network architecture configured based on a model of scattering of radiation by a material structure of a physical system along the radiation's path; and
   - training the neural network.
2. A method of determining a characteristic of a physical system having a material structure, the method comprising the steps:
   - receiving a trained neural network with its network architecture configured based on a model of scattering of radiation by the material structure along the radiation's path; and
   - using the trained neural network to determine the characteristic of the physical system.
3. The method of clause 1 or clause 2, wherein the network architecture is configured based on the model by configuring parameters selected from a group consisting of: number of units per hidden layer, number of hidden layers, layer interconnection and dropout.
4. The method of any preceding clause, wherein the step of providing a neural network comprises providing one or more skip connections between non-adjacent neural network layers based on reflection of radiation in the model of scattering of the radiation.
5. The method of any preceding clause, wherein different hidden layers of the neural network correspond to different scattering of the radiation along the radiation's path with different respective portions of the physical system.
6. The method of clause 5, wherein the portions comprise material discontinuities.
7. The method of clause 5 or clause 6, wherein the portions comprise interfaces between differing material layers.
8. The method of any preceding clause, wherein the step of providing the neural network comprises providing different units in a hidden layer corresponding to different respective types of scattering of the radiation with the material structure.
9. The method of clause 8, wherein the different respective types of scattering of the radiation to which differing units correspond are selected from a group of types of scattering consisting of: reflection, transmission, absorption, refraction, diffraction, interference, polarization, dispersion, elastic scattering, and inelastic scattering.
10. The method of any preceding clause, wherein the physical system comprises an optical system and the characteristic comprises an optical response of the optical system.
11. The method of any preceding clause, wherein the physical system comprises an acoustic system and the characteristic comprises an acoustic response of the acoustic system.
12. The method of any preceding clause, wherein the physical system comprises a multilayer on a substrate.
13. The method of any preceding clause, wherein the physical system comprises a lithographically patterned multilayer.
14. The method of any preceding clause, wherein the neural network having its architecture configured based on the model is further provided with a second neural network in parallel and wherein the neural networks share the same input and outputs.
15. A data processing apparatus, comprising a neural network with its network architecture configured based on a model of scattering of radiation by a material structure of a physical system along the radiation's path.
16. An inspection apparatus for reconstructing an approximate structure of physical system having a material structure, the inspection system comprising:
   - an illumination system configured to illuminate the physical system with radiation;
   - a detection system configured to detect a detected characteristic of physical system arising from the illumination; and
   - a processor configured to:
      - determine at least one model characteristic of the physical system using a method according to any of clauses 1 to 14; and
      - determine an approximate structure of the physical system from a difference between said detected characteristic and said at least one model characteristic of the physical system.
17. A metrology apparatus comprising the inspection apparatus of clause 16.
18. A lithographic cell comprising the inspection apparatus of clause 16.
19. A computer program product comprising machine readable instructions for causing a general-purpose data processing apparatus to perform the steps of a method as defined in any of clauses 1 to 14.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). It is also to be noted that the term metrology apparatus or metrology system encompasses or may be substituted with the term inspection apparatus or inspection system. A metrology or inspection apparatus as disclosed herein may be used to detect defects on or within a substrate and/or defects of structures on a substrate. In such an embodiment, a characteristic of the structure on the substrate may relate to defects in the structure, the absence of a specific part of the structure, or the presence of an unwanted structure on the substrate, for example.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of physical systems such as structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of a physical structure may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. With respect to the multi-sensitivity target embodiment, the different product features may comprise many regions with varying sensitivities (varying pitch etc.). Further, pitch p of the metrology targets is close to the resolution limit of the optical system of the scatterometer, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method of providing a trained neural network, the method comprising the steps:
- providing a neural network with its network architecture configured based on a model of scattering of radiation by a material structure of a physical system along the radiation's path; and
- training the neural network.

2. A method of determining a characteristic of a physical system having a material structure, the method comprising the steps:
- receiving a trained neural network with its network architecture configured based on a model of scattering of radiation by the material structure along the radiation's path; and
- using the trained neural network to determine the characteristic of the physical system.

3. The method of claim 1 or claim 2, wherein the network architecture is configured based on the model by configuring parameters selected from a group consisting of: number of units per hidden layer, number of hidden layers, layer interconnection and dropout.

4. The method of any preceding claim, wherein the step of providing a neural network comprises providing one or more skip connections between non-adjacent neural network layers based on reflection of radiation in the model of scattering of the radiation.

5. The method of any preceding claim, wherein different hidden layers of the neural network correspond to different scattering of the radiation along the radiation's path with different respective portions of the physical system,
and wherein, optionally, the portions comprise material discontinuities.

6. The method of claim 5, wherein the portions comprise interfaces between differing material layers.

7. The method of any preceding claim, wherein the step of providing the neural network comprises providing different units in a hidden layer corresponding to different respective types of scattering of the radiation with the material structure,
and wherein, optionally, the different respective types of scattering of the radiation to which differing units correspond are selected from a group of types of scattering consisting of: reflection, transmission, absorption, refraction, diffraction, interference, polarization, dispersion, elastic scattering, and inelastic scattering.

8. The method of any preceding claim, wherein the physical system comprises an optical system and the characteristic comprises an optical response of the optical system.

9. The method of any preceding claim, wherein the physical system comprises an acoustic system and the characteristic comprises an acoustic response of the acoustic system.

10. The method of any preceding claim, wherein the physical system comprises a multilayer on a substrate.

11. The method of any preceding claim, wherein the neural network having its architecture configured based on the model is further provided with a second neural network in parallel and wherein the neural networks share the same input and outputs.

12. A data processing apparatus, comprising a neural network with its network architecture configured based on a model of scattering of radiation by a material structure of a physical system along the radiation's path.

13. An inspection apparatus or metrology apparatus for reconstructing an approximate structure of physical system having a material structure, the inspection system comprising:
- an illumination system configured to illuminate the physical system with radiation;
- a detection system configured to detect a detected characteristic of physical system arising from the illumination; and
- a processor configured to:
- determine at least one model characteristic of the physical system using a method according to any of claims 1 to 11; and
- determine an approximate structure of the physical system from a difference between said detected characteristic and said at least one model characteristic of the physical system.

14. A lithographic cell comprising the inspection apparatus or metrology apparatus of claim 13.

15. A computer program product comprising machine readable instructions for causing a general-purpose data processing apparatus to perform the steps of a method as claimed in any of claims 1 to 11.
